(19) Europäisches Patentamt
European Patent Office
Office européen des brevets

(11) EP 3 051 594 A1

(12) DEMANDE DE BREVET EUROPEEN

(43) Date de publication:
03.08.2016 Bulletin 2016/31

(51) Int Cl.:
*H01L 31/0216* (2006.01)     *H01L 31/103* (2006.01)
*H01L 31/105* (2006.01)

(21) Numéro de dépôt: 16153424.3

(22) Date de dépôt: 29.01.2016

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR
Etats d'extension désignés:
BA ME
Etats de validation désignés:
MA MD

(30) Priorité: 02.02.2015 FR 1500182

(71) Demandeur: Commissariat à l'Energie Atomique et aux Energies Alternatives
75015 Paris (FR)

(72) Inventeurs:
• BADANO, Giacomo
  38250 LANS EN VERCORS (FR)
• KRISO, Christian
  70825 Korntal-Muenchingen (DE)

(74) Mandataire: Brevalex
95, rue d'Amsterdam
75378 Paris Cedex 8 (FR)

(54) **STRUCTURE SEMICONDUCTRICE À DEUX CAVITÉS RÉSONANTES COUPLÉES OPTIQUEMENT ET PROCÉDÉ DE FABRICATION D'UNE TELLE STRUCTURE**

(57) L'invention concerne une structure semiconductrice (10) destinée à recevoir une onde électromagnétique. La structure semiconductrice (10) comporte au moins une première cavité (110) optique résonnante semiconductrice conformée pour absorber au moins partiellement l'onde électromagnétique et pour fournir un signal électrique proportionnel à la partie de l'onde électromagnétique absorbée. La structure semiconductrice (10) comprend en outre une deuxième cavité (120) optique résonante diélectrique dont une longueur d'onde de résonance est comprise dans la gamme de longueurs d'onde prédéterminée et est préférentiellement égale à la longueur d'onde $\lambda_0$, la deuxième cavité (120) étant agencée pour intercepter au moins une partie de l'onde électromagnétique et étant couplée optiquement à la première cavité (110). La deuxième cavité (120) est transparente à la gamme de longueurs d'onde prédéterminée. L'invention concerne en outre un composant semiconducteur (1) comportant une telle structure semiconductrice (10) et un procédé de fabrication d'une telle structure semiconductrice (10).

FIG. 7

**Description**

**DOMAINE TECHNIQUE**

L'invention se rapporte au domaine de la détection et/ou la mesure de rayonnements électromagnétiques et aux structures semiconductrices permettant une telle détection et/ou mesure de rayonnements électromagnétiques.

**ÉTAT DE LA TECHNIQUE ANTÉRIEURE**

Les structures semiconductrices permettant une telle détection et/ou mesure de rayonnements électromagnétiques sont de types multiples et peuvent donc être aussi bien des structures semiconductrices de type photodiode, classique ou pin, destinées à être polarisées en inverse, que des structures semiconductrices de type photodiode à puits quantiques ou encore des structures du type photodétecteur à barrière.

Quel que soit le type de ces structures, elles présentent, en utilisation, un courant d'obscurité qui en limite la sensibilité. Ce courant d'obscurité a pour origine la génération de paires électron-trou non photo-générées dans la structure. Or cette génération a principalement lieu dans la zone active de la structure dans laquelle les photons sont absorbés pour générer le signal. Par conséquent, les courants d'obscurités sont généralement proportionnels au volume de la zone active. Cette zone active, pour maximiser le signal, doit occuper une grande partie du volume de la structure, s'étendant généralement sur la quasi-totalité de la surface de la structure et sur des épaisseurs de l'ordre de plusieurs micromètres, et est donc à l'origine d'un bruit important.

Ceci est d'autant plus vrai pour les structures adaptées pour fonctionner dans les longueurs d'onde infrarouge, ces dernières étant sujettes à un bruit important en raison de la faible largeur de bande interdite du matériau dans lequel elles sont formées. En effet, une faible largeur de bande interdite favorise la formation d'un courant d'obscurité tunnel dans la zone active.

Pour remédier à cet inconvénient, il est connu de concentrer le rayonnement électromagnétique dans une zone réduite de la structure dans laquelle est ménagée la zone active. Ainsi, la structure peut recevoir le rayonnement électromagnétique sur une surface importante sans pour autant nécessiter une zone active occupant un volume important.

Parmi les différentes possibilités de concentration, il est connu notamment du document FR 2992471 d'obtenir une telle concentration des rayonnements électromagnétique à partir d'une cavité optique résonnante.

On entend ci-dessus et dans le reste de ce document par cavité optique résonnante, une zone d'un composant optique, tel qu'une structure semiconductrice, configurée pour qu'une onde électromagnétique présentant une longueur d'onde donnée ou comprise dans une gamme de longueurs d'onde donnée, rentre en résonance lorsqu'elle pénètre dans ladite zone. Une telle cavité optique résonnante n'est pas forcément creuse puisqu'elle peut être, comme c'est le cas dans les technologies des lasers semiconducteurs, emplie d'un milieu actif. Pour une structure semiconductrice, une cavité optique résonnante est généralement emplie d'un ou plusieurs matériaux semiconducteurs.

Dans cette structure, la zone active de la structure, c'est-à-dire celle configurée pour absorber au moins partiellement l'onde électromagnétique à détecter et pour fournir un signal électrique proportionnel à la partie de l'onde électromagnétique absorbée, est en partie aménagée dans la cavité optique résonante. Ainsi, la zone active de la structure bénéficie de la focalisation offerte par la présence de la cavité optique résonnante.

Néa nmoins, le pouvoir focalisant d'une telle cavité optique reste limité. En effet, la cavité optique permet de focaliser la partie de l'onde électromagnétique reçue sur une surface s'étendant à sensiblement $(2 \lambda 0 / \pi)^2$ avec $\lambda 0$ la longueur d'onde de l'onde électromagnétique à détecter. Pour obtenir une surface de réception suffisante, il peut donc être nécessaire de prévoir plusieurs cavités optiques résonnantes pour une structure donnée augmentant d'autant le courant d'obscurité.

EXPOSÉ DE L'INVENTION

La présente invention vise à remédier à cet inconvénient et a ainsi pour but la fourniture d'une structure semiconductrice qui, tout en présentant une zone active de faible dimension par le bénéfice de l'utilisation d'une cavité optique résonnante, possède une surface de réception sur laquelle l'onde électromagnétique reçue est détectée qui peut être plus grande que celle d'une structure de l'art antérieur qui est limitée à une surface s'étendant à $(2 \lambda 0 / \pi)^2$.

L'invention concerne à cet effet, une structure apte à absorber une onde électromagnétique dans une gamme de longueurs d'onde prédéterminée qui est centrée autour d'une longueur d'onde $\lambda_0$, la structure semiconductrice comportant :

- au moins une première cavité optique résonnante semiconductrice dont une première longueur d'onde de résonnance est comprise dans la gamme de longueurs d'onde prédéterminée et est préférentiellement égale à la longueur

d'onde $\lambda_0$, ladite première cavité étant conformée pour absorber au moins partiellement l'onde électromagnétique et pour fournir un signal électrique proportionnel à la partie de l'onde électromagnétique absorbée.

La structure semiconductrice comprend en outre :

-    une deuxième cavité optique résonante diélectrique dont une longueur d'onde de résonance est comprise dans la gamme de longueurs d'onde prédéterminée et est préférentiellement égale à la longueur d'onde $\lambda_0$, la deuxième cavité étant agencée pour intercepter au moins une partie de l'onde électromagnétique et étant couplée optiquement à la première cavité,

la deuxième cavité étant transparente à la gamme de longueurs d'onde prédéterminée.

L'utilisation d'une telle deuxième cavité optique résonnante diélectrique permet de bénéficier de la section efficace de la cavité diélectrique pour recevoir la partie de l'onde électromagnétique tout en conservant une zone active semiconductrice de dimension contenue, celle-ci étant logée dans la première cavité. En effet, avec une telle structure semiconductrice c'est la deuxième cavité qui permet d'intercepter l'onde électromagnétique, le couplage optique permettant de transmettre l'onde ainsi interceptée dans la première cavité dans laquelle elle sera absorbée. Or, de par son caractère diélectrique, la deuxième cavité ne présente pas les mêmes contraintes de dimensionnement qu'une cavité semiconductrice. Il en résulte qu'une structure comportant une telle deuxième cavité permet d'obtenir une section efficace plus importante que celle obtenue par une focalisation par une cavité semiconductrice utilisée dans l'art antérieur, ceci tout en conservant une taille de la zone active contenue.

Ainsi une telle structure permet de bénéficier de l'utilisation de la première cavité optique résonnante et possède une surface de réception, c'est-à-dire une section efficace, sur laquelle l'onde électromagnétique reçue est détectée qui peut être plus grande que celle d'une structure de l'art antérieur qui est limitée à une surface s'étendant à $(2 \lambda 0 / \pi)^2$.

Par « deuxième cavité couplée optiquement à la première cavité », il faut entendre que les première et deuxième cavités présentent des dimensionnements et un agencement l'une par rapport à l'autre adaptés pour que lorsqu'une onde électromagnétique dont la longueur d'onde est comprise dans la gamme de longueurs d'onde prédéterminée pénètre dans l'une de la première et deuxième cavité, elle est susceptible d'être au moins partiellement transmise vers l'autre de la première et deuxième cavité. Un tel couplage optique est plus généralement connu sous la dénomination de couplage optique évanescent.

La deuxième cavité peut comporter un indice optique $N_2$ inférieur à 2 et préférentiellement inférieur ou égal à 1,4.

Avec un tel indice optique, la deuxième cavité présente un indice de faible valeur vis-à-vis de celui d'un matériau semiconducteur tel que celui de la première cavité. Il en résulte un bon transfert par couplage optique de l'onde électromagnétique de la deuxième cavité dans la première cavité lorsque l'onde électromagnétique pénètre dans la deuxième cavité.

Par indice optique de la première cavité, il faut entendre, ici et dans le reste de ce document l'indice de réfraction optique effectif dans la gamme de longueurs d'onde prédéterminée. Ainsi lorsque le matériau de la première cavité est un matériau semiconducteur sensiblement homogène, l'indice optique est la partie réelle de l'indice de réfraction optique de ce même matériau semiconducteur. Par contre lorsque la première cavité est formée de plusieurs matériaux semiconducteurs, tels que par exemple, de plusieurs couches de matériaux semiconducteurs formant des multi-puits quantiques, l'indice optique de la première cavité est la partie réelle de l'indice optique effectif, c'est-à-dire l'indice de réfraction optique équivalent, du métamatériau formé par ces plusieurs matériaux. Une telle notion d'indice optique effectif étant par ailleurs connue de l'homme du métier notamment du document FR 2992471, elle n'est pas décrite plus en détail dans ce document.

La deuxième cavité peut être réalisée dans un matériau sélectionné dans le groupe comportant les verres, les polymères thermoplastiques, les élastomères, les polymères thermodurcissables, les résines photosensibles et les mélanges de deux ou plus de ces matériaux.

De tel matériau diélectrique présente l'avantage, en plus de la possibilité d'obtention d'indice optique inférieur ou égal à 1,4, de pouvoir être aisément mis en forme afin de définir la deuxième cavité. La fabrication d'une structure semiconductrice comportant un tel matériau pour sa deuxième cavité est donc d'autant plus facilitée.

La structure semiconductrice peut être apte à recevoir l'onde électromagnétique selon une direction d'émission moyenne, la première cavité pouvant être dimensionnée pour présenter au moins une première direction de résonance, correspondant à la première longueur d'onde de résonance, qui est sensiblement transversale à la direction d'émission.

Une structure comportant une telle première cavité bénéficie particulièrement du principe de l'invention. En effet, le couplage optique entre la première optique étant résonnant selon une direction transversale à la direction d'émission, la première cavité peut présenter une dimension selon la direction d'émission suffisante pour obtenir une bonne absorption de l'onde électromagnétique. La section efficace définie selon la direction transversale à la direction étant liée aux dimensions de la deuxième cavité, il est possible d'obtenir une section efficace importante avec une bonne absorption.

La première cavité peut présenter une première largeur $L_1$ selon la première direction de résonnance, la deuxième cavité présentant selon au moins cette même première direction de résonnance une deuxième largeur $L_2$ respectant l'équation suivante : $L_2 = L_1 \times M \times \dfrac{N_2}{N_1}$, avec $L_2$ la deuxième largeur, $L_1$ la première largeur, M un nombre entier impair supérieur ou égal 1, $N_1$ et $N_2$ les indices optiques respectif de la première et la deuxième cavité.

Une telle dimension $L_2$ permet d'obtenir un bon couplage optique résonnant entre la première et la deuxième cavité. Le transfert de l'onde électromagnétique de la deuxième cavité vers la première cavité lorsqu'elle pénètre dans la deuxième cavité est ainsi particulièrement efficace.

La structure semiconductrice peut comprendre un support présentant une première et une deuxième face opposée l'une à l'autre, la première cavité étant disposée en contact sur la première face et la deuxième cavité étant disposée en contact sur la deuxième face, le support étant dimensionné afin d'assurer le couplage optique entre la première et la deuxième cavité.

Un tel support est particulièrement avantageux pour permettre de contacter la zone active de la structure se trouvant dans la première cavité. On peut également noté, qu'un tel support pouvant être commun à plusieurs structures, il facilite leur disposition afin de former un composant comportant plusieurs structures.

La structure semiconductrice peut être une structure du type sélectionnée dans le groupe comportant les photodiodes du type pin, les photodiodes à puits quantiques, les photodétecteurs de type barrière, la zone active de ladite structure semiconductrice pouvant être aménagée dans la première cavité.

La structure semiconducteur peut comprendre au moins deux premières cavités, lesdites premières cavités étant chacune couplée optiquement à la deuxième cavité.

Une telle structure présente une multitude de première cavité et gagné en absorption de l'onde électromagnétique. Le taux d'absorption étant amélioré, la sensibilité de la structure est donc optimisée.

L'invention concerne également un composant semiconducteur comportant une pluralité de structures semiconductrices chacune destinée à recevoir une onde électromagnétique, ledit composant étant caractérisé en ce qu'au moins l'une, préférentiellement la totalité, des structures semiconductrices est une structure semiconductrice selon l'invention.

Un tel composant comportant une structure selon l'invention, bénéficie des avantages qui y sont liés.

L'invention concerne également un procédé de fabrication d'une structure semiconductrice apte à absorber une onde électromagnétique dans une gamme de longueurs d'onde prédéterminée qui est centrée autour d'une longueur d'onde $\lambda_0$,

le procédé comportant les étapes suivantes :

- fourniture d'au moins une première cavité optique résonnante semiconductrice dont une première longueur d'onde de résonnance est comprise dans la gamme de longueurs d'onde prédéterminée et est préférentiellement égale à la longueur d'onde $\lambda_0$, ladite première cavité étant conformée pour absorber au moins partiellement l'onde électromagnétique et pour fournir un signal électrique proportionnel à la partie absorbée de l'onde électromagnétique,

- fourniture d'une deuxième cavité optique résonante diélectrique dont une deuxième longueur d'onde de résonnance est comprise dans la gamme de longueurs d'onde et est préférentiellement égale à la longueur d'onde $\lambda_0$, la deuxième cavité étant agencée pour intercepter une partie de l'onde électromagnétique et étant couplée optiquement à la première cavité,

la deuxième cavité étant transparente à la gamme de longueurs d'onde prédéterminée.

Un tel procédé permet la fabrication d'une structure selon l'invention et donc bénéficiant des avantages qui y sont liés.

L'étape de fourniture de la première cavité peut comporter les sous-étapes suivantes :

- fourniture d'un support semiconducteur comportant une première et une deuxième face,
- formation de la première cavité en contact avec la première face du support,

et dans lequel l'étape de fourniture d'une deuxième cavité consiste à former ladite deuxième cavité en contact avec la deuxième face du support.

Un tel support est particulièrement avantageux pour permettre de contacter la zone active de la structure se trouvant dans la première cavité. On peut également noté, qu'un tel support pouvant être commun à plusieurs structures, il facilite leur disposition afin de former un composant comportant plusieurs structures.

L'étape de fourniture de la deuxième cavité peut comporter les sous-étapes suivantes :

- dépôt d'une couche de résine photosensible sur la surface du support, par exemple par centrifugation,
- insolation d'une partie de la couche de résine photosensible, cette partie étant la partie destinée à former la deuxième cavité, si la résine photosensible est du type résine positive, ou le reste de la couche de résine photosensible, si cette dernière u résine photosensible est du type résine négative,
- révélation de la deuxième cavité par l'utilisation d'un solvant.

De telles sous-étapes permettent d'obtenir la formation de la deuxième cavité avec un nombre réduit d'opération. En effet, la résine photosensible servant elle-même à la formation de la deuxième cavité, il n'est pas nécessaire de réalisé une quelconque opération de gravure, la cavité étant formée lors de l'opération de révélation.

## BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

- les figures 1A à 1C illustrent schématiquement trois possibilités d'agencement d'une structure semiconductrice selon le principe de l'invention,
- les figures 2A et 2B sont respectivement un premier et un deuxième graphique illustrant la variation de l'efficacité quantique d'une structure semiconductrice illustrée sur la figure 1B en fonction de l'espacement entre une première et une deuxième cavité optique résonnante de ladite structure semiconductrice pour respectivement une gamme de longueurs d'onde entre 4 et 5 $\mu$m et une gamme de longueurs d'onde entre 8 et 10 $\mu$m,
- les figures 3A et 3B sont des graphiques illustrant la variation de l'efficacité quantique d'une structure semiconductrice illustrée sur la figure 1B en fonction de la hauteur et de la largeur de la deuxième cavité optique résonnante de ladite structure semiconductrice pour respectivement une gamme de longueurs d'onde entre 4 et 5 $\mu$m et une gamme de longueurs d'onde entre 8 et 10 $\mu$m,
- les figures 4A et 4B sont des graphiques illustrant la variation de l'efficacité quantique d'une structure semiconductrice illustrée sur la figure 1B en fonction de la hauteur et de la largeur de la deuxième cavité optique résonnante de ladite structure semiconductrice pour respectivement une structure semiconductrice comportant quatre premières cavités optiques résonnantes et une structure semiconductrice comportant six premières cavités optiques résonnantes,
- les figures 5.1 à 5.6 illustrent les principales étapes de fabrication d'une structure semiconductrice selon l'invention,
- la figure 6 illustre une structure semiconductrice selon l'invention dans laquelle la deuxième cavité optique résonnante comporte l'une des deux zones dopées séparées par une barrière de potentiel d'une structure du type photodiode à barrière,
- la figure 7 illustre une structure semiconductrice selon l'invention dans laquelle la deuxième cavité optique résonnante comporte la partie absorbante d'une structure du type photodétecteur à puits quantiques,
- la figure 8 illustre une structure semiconductrice selon l'invention comprenant plusieurs premières cavités optiques résonnantes,
- la figure 9 illustre un composant semiconducteur comportant une pluralité de structures semiconductrices selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

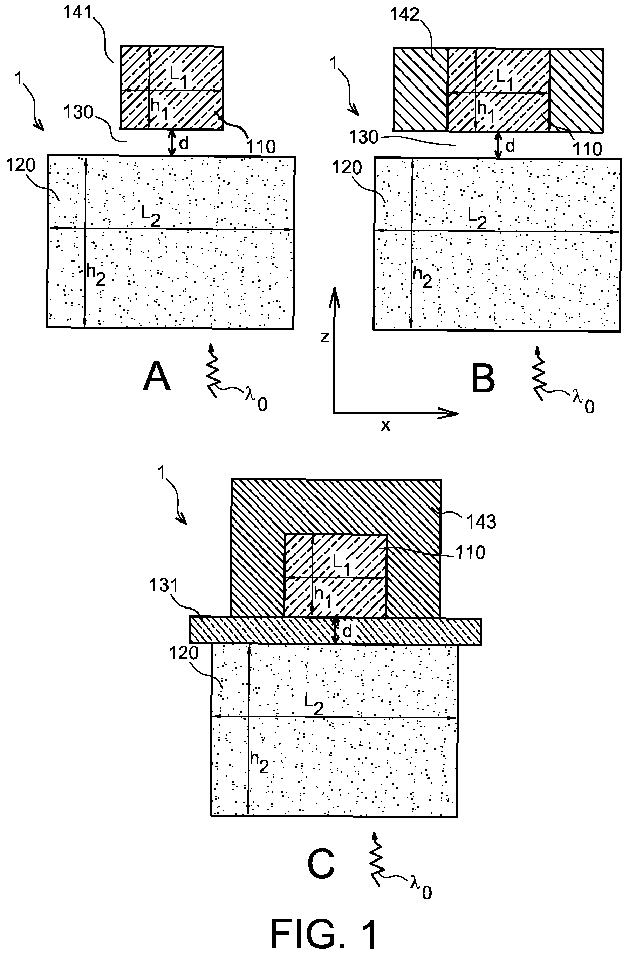

Les figures 1A à 1C illustrent schématiquement trois exemples d'arrangement d'une structure semiconductrice 10 selon le principe de l'invention, une telle structure étant destinée à recevoir une onde électromagnétique dans une gamme de longueurs d'onde prédéterminée centrée autour d'une longueur d'onde $\lambda_0$. En d'autre terme, la structure est apte à absorber une onde électromagnétique dans une gamme de longueurs d'onde prédéterminée qui est centrée autour d'une longueur d'onde $\lambda_0$. Ladite structure semiconductrice 10 est destinée à recevoir l'onde électromagnétique selon une direction d'émission z moyenne qui est représenté sur la figure 1B par l'axe z. Une telle direction d'émission moyenne est sensiblement transversale par rapport à une surface de réception de la structure semiconductrice 10.

Si dans la suite de ce document les exemples et les valeurs donnés concernent plus particulièrement les structures semiconductrices destinées à recevoir une onde électromagnétiques dans une gamme de longueurs d'onde comprise dans les infrarouges, l'invention ne se limite pas aux seuls infrarouges. En effet, sur la base des enseignements donnés dans ce document et à partir de ses connaissances générales, l'homme du métier est bien entendu à même de transposer le principe de l'invention à des structures semiconductrices aptes à recevoir des ondes électromagnétiques dans des gammes de longueurs d'onde autres que l'infrarouge, telles que les gammes de longueurs d'onde du visible ou des ultraviolets.

Une telle structure semiconductrice, telle qu'illustrée sur la figure 1A, comporte une première et deuxième cavité 110, 120 optique résonnante espacées l'une de l'autre par un espace de couplage 130 d'épaisseur d.

La première cavité 110 est une cavité optique résonnante semiconductrice dont une première longueur d'onde de résonnance est comprise dans la gamme de longueurs d'onde prédéterminée. Plus précisément, la première longueur d'onde de résonnance est préférentiellement égale à la longueur d'onde $\lambda_0$ centrale de la gamme de longueurs d'onde prédéterminée. La première longueur d'onde de résonnance de la première cavité 110 est définie par un dimensionnement adéquat de la première cavité 110 et par des moyens de confinement disposés de part et d'autre de la première cavité 110.

Un tel dimensionnement de la première cavité 110 est connu de l'art antérieur et notamment du document FR 2992471.

Ainsi la première cavité 110 présente au moins une dimension $L_1$ selon une direction x sensiblement transversale à la direction d'émission z moyenne qui est adaptée pour présenter une longueur d'onde de résonnance. Pour une structure semiconductrice 10 adaptée pour recevoir un'onde électromagnétique dans la gamme de longueurs d'onde de l'infrarouge moyen (également connue sous son sigle anglais MWIR pour « Mid-Wave InfraRed »), c'est-à-dire comprise entre 3 et 5 $\mu$m, la première cavité peut présenter au moins une dimension $L_1$ transversale à la direction d'émission qui est de 1 $\mu$m. Pour un'onde électromagnétique comprise dans la gamme de longueurs d'onde de l'infrarouge lointain (également connue sous son sigle anglais LWIR, pour Long-Wave InfraRed), c'est-à-dire compris entre 8 $\mu$m et 12 mm, la première cavité 110 peut présenter au moins une dimension $L_1$ transversale à la direction d'émission z qui est de 2 $\mu$m. Bien entendu, afin d'optimiser le confinement optique de l'onde électromagnétique incidente, la première cavité optique résonnante 110 peut présenter une forme assurant une résonance sur au moins deux directions transversales à la direction d'émission z. Ainsi la première cavité 110 peut présenter une section transversale par rapport à la direction d'émission z carrée de côté $L_1$ ou encore une section transversale par rapport à la direction d'émission z circulaire de diamètre $L_1$.

La dimension $h_1$ de la première cavité 110 selon la direction d'émission z peut être choisie afin d'optimiser l'absorption de la onde électromagnétique. Ainsi si la structure semiconductrice 10 est adaptée pour recevoir une onde électromagnétique dans la gamme de longueurs d'onde de l'infrarouge moyen, la dimension $h_1$ de la première cavité 110 selon la direction d'émission z est préférentiellement supérieure ou égale à 400 nm. Pour une première onde électromagnétique comprise dans la gamme de longueurs d'onde de l'infrarouge lointain, la dimension $h_1$ de la première cavité 110 selon la direction d'émission z est préférentiellement supérieure ou égale à 800 nm.

Dans l'exemple d'agencement illustré sur la figure 1A, les moyens de confinement sont fournis par une rupture d'indice optique entre le matériau de la première cavité 110 et le matériau 141 entourant la première cavité qui si il est ici de l'air, peut être un autre matériau présentant un faible indice optique, tel qu'un matériau diélectrique présentant un indice optique inférieur à 1,5. Ainsi pour un matériau semiconducteur de la première cavité 110 d'indice $N_1$ de 3,5+0,2i, la partie imaginaire correspondant à l'absorbance, et de l'air en tant que matériau entourant la cavité, d'indice optique No de 1, on a un rapport d'indice optique fort de 3,5 qui permet de fournir une bon confinement de la partie de l'onde électromagnétique pénétrant la première cavité 110.

La première cavité 110 est conformée pour absorber au moins partiellement l'onde électromagnétique et pour fournir un signal électrique proportionnel à la partie absorbée de l'onde électromagnétique. Comme indiqué dans le paragraphe précédent, une telle absorbance est fournie par un matériau semiconducteur présentant dans la gamme de longueurs d'onde prédéterminée un indice optique dont la partie imaginaire est non nulle, égale par exemple à 0,2i. La première cavité 110 comporte une zone active de la structure semiconductrice 10 ceci afin que la première cavité 110 présente la conformation adaptée pour fournir un signal électrique proportionnel à la partie de la première onde électromagnétique absorbée.

Ainsi, pour une structure semiconductrice 10 sélectionnée dans le groupe comportant les photodiodes classiques, les photodiodes du type pin, les photodiodes à puits quantiques, les photodétecteurs de type barrière, la première cavité 110 comporte respectivement l'une des zones dopées de la photodiode classique, la zone intrinsèque de la photodiode du type pin, les puits quantiques de la photodiode à puits quantiques et l'une des deux zones dopées du photodétecteur de type barrière.

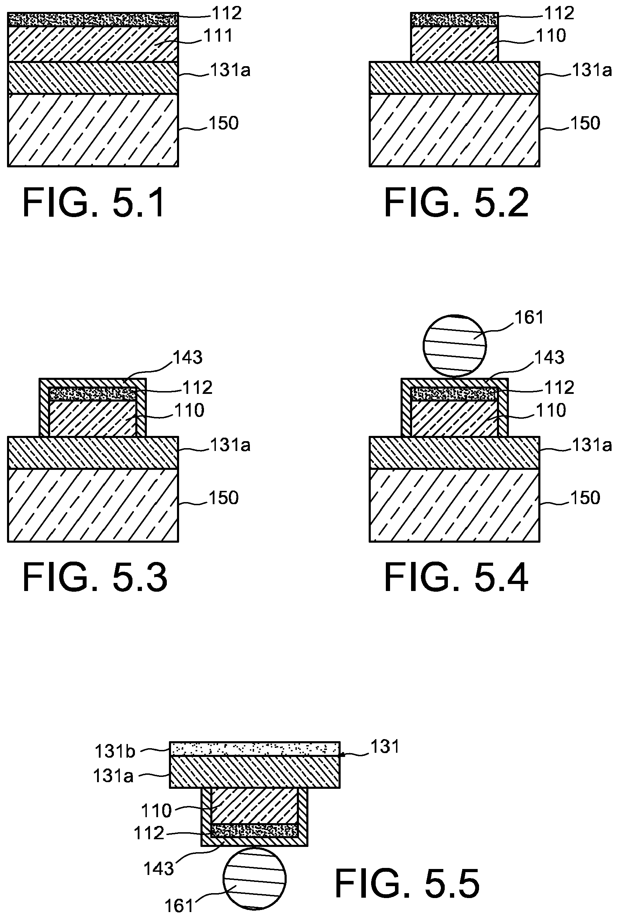

De telles parties actives sont connues de l'art antérieur, on peut notamment citer le document FR 2992471, l'article scientifique de B.F Levine publié dans la revue scientifique « Journal of Applied Physics » en 1993 volume 74 pages R1 à R81, et le document FR 2985373. Pour ces raisons, mis à part les exemples de réalisation qui sont décrits ci-dessous en lien avec les figures 5.1 à 5.6, 6 et 7, elles ne sont pas décrites de manière plus détaillée dans ce document.

On peut néa nmoins noter que dans le cadre d'une application du principe de l'invention pour la détection dans les gammes de longueurs d'onde des infrarouges, la première cavité 110 peut être réalisée dans au moins l'un des matériaux sélectionnés dans le groupe comportant l'arséniure de gallium GaAs, l'antimoniure d'indium InSb, l'antimoniure de gallium GaSb et les semiconducteurs ternaires tels que les Arséniure de gallium-aluminium $Al_xGa_{1-x}As$, les tellurures de mercure-cadmium $Hg_{1-x}Cd_xTe$ et les Arséniure de gallium-indium $In_xGa_{1-x}As$ avec x compris entre 0 et 1.

Au moins un matériau semiconducteur constituant la première cavité est choisi pour être absorbant dans la gamme de longueurs d'onde. Un tel choix peut notamment être fait en choisissant un matériau présentant une largeur de bande interdite d'énergie inférieur à l'énergie correspondant à la borne supérieure de la gamme de longueurs d'onde. Ainsi si on prend l'exemple de gammes compris dans les infrarouges et les tellurures de mercure-cadmium $Hg_{1-x}Cd_xTe$ dont la largeur de bande interdite varie avec la composition x en cadmium, il possible de définir les choix suivants :

- pour gamme de longueurs d'onde des infrarouges moyens inférieurs à 3$\mu$m (donc borne supérieure à 3 $\mu$m), la proportion minimum en cadmium x peut être supérieure à 0,5,
- pour la gamme de longueurs d'onde des infrarouges moyens inférieurs à 5 $\mu$m (donc borne supérieure à 5 $\mu$m), la proportion en cadmium x peut être supérieure à 0,4,
- pour une gamme de longueurs d'onde des infrarouges lointains inférieurs à 10 $\mu$m (donc borne supérieure à 10 $\mu$m), la proportion minimale en cadmium x peut être supérieure à 0,3.

Plus généralement, il est à noter que pour une gamme de longueurs d'onde des infrarouges, au moins un matériau de la première cavité présente une largeur de bande interdite comprise entre 0 eV (0 eV exclut) à 1,4 eV.

La deuxième cavité 120 est une cavité optique résonante diélectrique. Le matériau constituant la deuxième cavité peut être sélectionné dans le groupe comportant les verres, les polymères thermoplastiques, les élastomères, les polymères thermodurcissables, les résines photosensibles et les mélanges de deux ou plus de ces matériaux. Ledit matériau peux comporter en outre un élément dopant afin d'obtenir un indice de réfraction adapté. Le matériau constituant la deuxième cavité 120 présente un indice de réfraction inférieur ou égal à 2 et préférentiellement inférieur à 1,5. Le matériau de la deuxième cavité 120 peut ainsi être par exemple une résine photosensible telle que la résine AZ®4562 commercialisé par Clariants® qui présente un indice de réfraction de 1,4.

Afin d'assurer un couplage optique entre la première et la deuxième cavité 110, 120, la deuxième cavité optique résonnante est accordée en longueurs d'onde de résonance avec la première cavité 110. Un tel accord en résonance peut être obtenu par une deuxième largeur $L_2$ de la cavité de la deuxième cavité respectant l'équation suivante :

$$L_2 = L_1 \times M \times \frac{N_2}{N_1} \qquad (1)$$

avec $L_2$ la deuxième largeur, $L_1$ la première largeur, M un nombre entier impair supérieur ou égal 1, $N_1$ et $N_2$ les indices optiques respectif de la première et la deuxième cavité 120. De même que pour la première cavité 110, la deuxième cavité 120 peut être dimensionnée pour optimiser l'accord en longueur d'onde de résonance avec la première cavité 110. Ainsi, la deuxième cavité peut présenter une forme assurant un accord de résonance sur au moins deux directions transversale à la direction d'émission z moyenne. Ainsi, la deuxième cavité optique 120 résonnante peut présenter une section transversale par rapport à la direction d'émission carrée de côté $L_2$ ou encore une section transversale par rapport à la direction d'émission circulaire de diamètre $L_2$.

La dimension $h_2$ de la deuxième cavité 120 selon la direction d'émission z est adaptée pour présenter une longueur d'onde de résonance ou une harmonique de cette longueur d'onde de résonance comprise dans la gamme de longueurs d'onde prédéterminée. De cette manière, la deuxième cavité 120 est adaptée pour recevoir la première onde électromagnétique et la transmettre à la première cavité 110 par le couplage optique existant entre la première et la deuxième cavité 110, 120. Le confinement de la radiation électromagnétique dans la première cavité est particulièrement favorisé par une différence d'indice optique $N_1$-$N_2$ important entre la première et la deuxième cavité.

On peut noter que les dimensions $L_2$ et $h_2$ sont préférentiellement choisies comme grandes par rapport à la longueur d'onde $\lambda_0$ de manière à ce que la structure semiconductrice 10 présente une section efficace importante. On notera ainsi, que les dimensions $L_2$ et $h_2$ de la deuxième cavité 120, sous réserve des conditions dimensionnelles énoncées ci-dessus soient respectées, sont de l'ordre de la taille de pixel d'un composant comportant de telles structures semiconductrices 10, c'est-à-dire compris entre 3 et 40 $\mu$m.

Le couplage entre la première et la deuxième cavité 110, 120 est également optimisé par l'utilisation d'une distance d entre elles deux qui est adaptée. En effet, la distance d entre la première et la deuxième cavité 110, 120 est suffisamment faible pour autoriser un couplage optique entre la première et la deuxième cavité 110, 120. Qui plus est, cette distance d peut être choisie pour maximiser le couplage entre la première et la deuxième ceci en fonction des dimensions des première et deuxième cavités, des matériaux qui les composent et de l'indice optique du ou des matériaux constituant l'espace entre la première et la deuxième cavité 110, 120. Comme cela sera montré dans la suite de ce document, une telle optimisation de la distance d entre la première et la deuxième cavité peut être obtenue au moyen de simples calculs de routine à la portée de l'homme du métier ayant eu connaissance de la présente divulgation.

Le couplage de la première et deuxième cavité 110, 120 peut également être optimisé en adaptant le positionnement de la deuxième cavité 120 par rapport à la première cavité 120 dans les directions transversales à la direction d'émission z. Ainsi la première et la deuxième cavité 110, 120 sont préférentiellement centrée l'une par rapport à l'autre. Dans le cas où la première cavité et la deuxième cavité 110, 120 présentent toutes deux une section carrée ou circulaire, les centres des sections de la première et de la deuxième cavité 110, 120 sont alignés selon la direction z.

La deuxième cavité 120 est agencée par rapport à la première cavité 110 pour intercepter au moins une partie de la première onde électromagnétique. Un tel agencement de la deuxième cavité 120 est obtenu par une disposition de la deuxième cavité en amont de la première cavité selon la direction d'émission z.

La figure 1B illustre schématique une structure semiconductrice 10 selon une deuxième possibilité d'agencement selon l'invention dans laquelle le confinement de la première cavité 110 est fourni par l'utilisation d'un matériau réfléchissant 142, tel qu'un matériau métallique. Une structure semiconductrice 10 selon cette deuxième possibilité d'agencement se différencie d'une structure selon la première possibilité d'agencement en ce que la première cavité 110 est bornée par le matériau réfléchissant 142 sur au moins deux de ses côtés et selon au moins une direction x sensiblement transversale à la direction d'émission z.

Le matériau réfléchissant 142 peut être un matériau métallique préférentiellement choisi parmi l'or, l'aluminium et le cuivre. Selon cette même deuxième possibilité d'agencement, le matériau réfléchissant peut également être un assemblage de couches semiconductrices formant un miroir de Bragg dont la gamme de longueurs d'onde réfléchie est centrée autour de la longueur d'onde $\lambda_0$.

De même que pour la première possibilité d'agencement décrite ci-dessus et afin d'optimiser le confinement optique de la première onde électromagnétique, la première cavité 110 selon cette deuxième possibilité d'agencement, peut présenter une forme assurant une résonnance sur au moins deux directions transversales à la direction d'émission z. Ainsi la première cavité 110 peut présenter une section transversale par rapport à la direction d'émission z carrée de côté $L_1$ avec le matériau réfléchissant sur chacun des quatre côtés. La première cavité 110 peut également présenter une section transversale par rapport à la direction d'émission z circulaire de diamètre $L_1$ le matériau réfléchissant étant disposé sur le pourtour du cercle.

La dimension $L_1$ de la première cavité 110 selon au moins une direction transversale à la direction d'émission z est adaptée pour prendre en compte la présence du matériau réfléchissant 142. Ainsi pour une structure semiconductrice 10 adaptée pour recevoir une première onde électromagnétique dans la gamme de longueurs d'onde de l'infrarouge moyen remplie d'un matériau absorbant d'indice par exemple 3,5, la première cavité peut présenter au moins une dimension $L_1$ transversale à la direction d'émission qui est de 1,2 $\mu$m. Pour une première onde électromagnétique comprise dans la gamme de longueurs d'onde de l'infrarouge lointain, la première cavité 110 peut présenter au moins une dimension $L_1$ transversale à la direction d'émission z qui est de 2,4 $\mu$m. Plus généralement, selon cette deuxième possibilité d'agencement, la dimension $L_1$ de la première cavité 110 selon au moins une direction transversale à la direction d'émission z peut suivre la formule décrite dans le document FR 2992471, c'est-à-dire $L_1 = \lambda_0/2n_{eff}$ avec neff l'indice optique , c'est-à-dire ici l'indice de réfraction effectif du mode propre de la première cavité 110.

La figure 1C illustre schématique une structure semiconductrice 10 selon une troisième possibilité d'agencement selon l'invention qui se différencie d'une structure semiconductrice 10 selon la deuxième possibilité d'agencement en ce que la première et la deuxième cavité 110, 120 sont séparée l'une de l'autre par un support 131 et en ce que la première cavité 110 comporte également sur sa partie opposée à la deuxième cavité 120 le matériau réfléchissant 143.

Cette troisième possibilité d'agencement est plus représentative d'une structure semiconductrice 10 selon l'invention telle qu'elle peut être mise en oeuvre. En effet, un tel support 131 facilite l'agencement de plusieurs structures semiconductrices 10 afin de former un composant semiconducteur et permet en outre d'y ménager une partie non active (en opposition à la zone active précitée) et absorbante de la structure semiconductrice 10 telles que l'une des zones p ou n d'une photodiode pin ou d'une photodiode à puits quantiques, ou l'une des zones dopées et la barrière de potentiel d'un photodétecteur de type barrière. La première et la deuxième possibilité d'agencement doivent en effet faire appel à un matériau d'encapsulation ou à un système de maintien afin d'assurer le positionnement entre la première et la deuxième cavité 110, 120.

Qui plus est, selon cette troisième possibilité d'agencement de l'invention, le matériau réfléchissant, lorsqu'il s'agit d'un matériau conducteur, tel qu'un matériau métallique, peut faire office de contact métallique afin de polariser la structure. Selon cette possibilité, la première cavité peut comporter au niveau de ses côtés et/ou de sa partie opposée à la deuxième cavité 120 une couche de passivation offrant une isolation électrique, non illustrée sur la figure 1C, afin de fournir un contact électrique localisé uniquement sur un emplacement bien défini de la première cavité 110.

La présence du matériau réfléchissant au niveau de la partie de la première cavité 110 qui est opposée à la deuxième cavité 120 permet d'obtenir un meilleur confinement de la première longueur d'onde lorsqu'elle pénètre dans la première cavité.

Le dimensionnement de la première cavité 110 selon cette troisième possibilité d'agencement est similaire à celui décrit pour la structure semiconductrice 10 selon la deuxième possibilité d'agencement.

Bien entendu, ces trois possibilités d'agencement ne sont données qu'à titre d'illustration du principe de l'invention et ne sont nullement limitatives, les caractéristiques de chacune d'entre elles n'étant nullement exclusives. Ainsi, la première possibilité d'agencement, tout comme la deuxième possibilité d'agencement, sont bien entendu compatibles avec la présence d'un support 131, la distance d étant alors adaptée pour tenir compte de l'indice de réfraction du support 131.

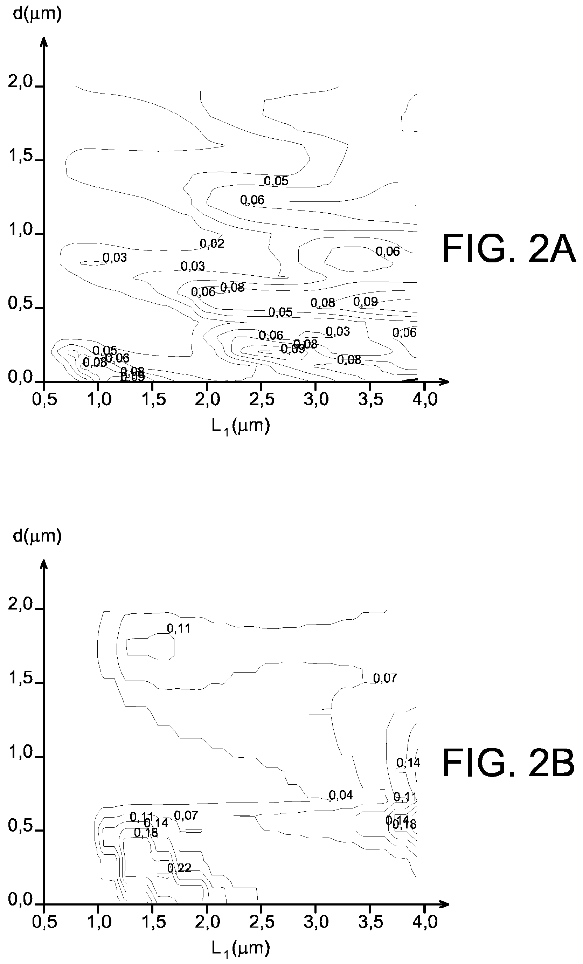

Les figures 2A à 3B illustrent des exemples de calculs de la variation de l'efficacité quantique d'une structure semiconductrice selon l'invention permettant de définir les dimensions de la deuxième cavité 120 et de la distance d entre la première et la deuxième cavité 110, 120. Ces calculs sont obtenus par des simulations par éléments finis qui sont parfaitement réalisables pour un homme du métier ayant connaissance de la présente divulgation et qui peuvent être réalisées dans le cadre d'essais de routine afin d'optimiser le dimensionnement d'une structure semiconductrice 10 selon l'invention. De tels calculs montrent notamment que l'optimisation de la distance d de couplage entre la première et la deuxième cavité 110, 120 est principalement dépendante de la dimension $L_1$ de la première cavité 110 selon au moins une direction transversale à la direction d'émission z, les dimensions de la deuxième cavité n'ayant qu'une faible influence.

Ainsi les figures 2A et 2B illustrent respectivement la variation de l'efficacité quantique pour une structure semiconductrice 10 telle qu'illustrée sur la figure 1B comportant une première cavité 110 de section carrée dont la dimension $h_1$ selon la direction d'émission z est égale à 400 nm pour la figure 2A et 800 nm pour la figure 2B. L'indice optique du matériau de la première cavité 100 pour ces calculs a été fixé à 3,4 +0,2i. La figure 2A correspond à l'efficacité quantique dans la gamme de longueurs d'onde allant de 4 à 5 $\mu$m tandis que la figure 2B correspond la gamme de longueurs d'onde allant de 8 à 10 $\mu$m.

On peut voir sur ces deux figures que pour une dimension $L_1$ donnée de la première cavité 110, la distance entre la première et la deuxième cavité 110, 120 présente plusieurs optimums pour lesquels l'efficacité quantique est maximale. Ceci est vrai aussi bien pour la gamme de longueurs d'onde allant de 4 à 5 $\mu$m que pour la gamme de longueurs d'onde allant de 8 à 10 $\mu$m.

Sur la base des résultats des calculs illustrés sur les figures 2A et 2B, il est donc possible de fournir les dimensions d de l'espace 130 qui, en association à une dimension $L_1$ donnée de la première cavité 110, permet d'aboutir à une efficacité quantique optimale. En effet, la dimension $L_1$ de la première cavité est déterminée en fonction de la longueur d'onde $\lambda_0$ centrale de la gamme de longueurs d'onde prédéterminée de l'onde électromagnétique. Ainsi, en considérant un indice optique de 3,4 pour la première cavité 110 et un indice de l'espace 130 entre la première et la deuxième cavité 110,120 de 3,4, il est possible d'aboutir au tableau 1 ci-dessous qui illustre cette possibilité en fournissant 4 à 5 dimensions d optimales pour 3 gammes de longueurs d'onde dans les infrarouges.

**Tab.1 : Dimensions d optimales de l'espace entre la première et la deuxième cavité pour respectivement la gamme de longueurs d'onde de 3 à 5 $\mu$m, de 8 à 10 $\mu$m et pour 100 $\mu$m ceci pour un espace d'indice optique de 3,4.**

| Gamme | d1 | d2 | d3 | d4 | d5 |
|---|---|---|---|---|---|
| **3 à 5 $\mu$m** | 200 $\pm$ 100 nm | 800 $\pm$ 100 nm | 1300 $\pm$ 100 nm | 1900 $\pm$ 100 nm | |
| **8 à 10 $\mu$m** | 300 $\pm$ 200 nm | 1700 $\pm$ 200 nm | 2900 $\pm$ 200 nm | 4000 $\pm$ 200 nm | 5300 $\pm$ 200 nm |
| **100 $\mu$m** | 5,5 $\pm$ 1 $\mu$m | 20 $\pm$ 1 $\mu$m | 35 $\pm$ 1 $\mu$m | 50 $\pm$ 1 $\mu$m | 64 $\pm$ 1 $\mu$m |

Pour un espace 130 entre la première et la deuxième cavité présentant un indice optique de 1,4, les valeurs sont données dans le tableau 2 ci-dessous.

**Tab.2 : Dimensions d optimales de l'espace entre la première et la deuxième cavité pour respectivement la gamme de longueurs d'onde de 3 à 5 $\mu$m, de 8 à 10 $\mu$m et pour 100 $\mu$m ceci pour un espace d'indice optique de 1,4.**

| Gamme | d1 | d2 | d3 | d4 | d5 |
|---|---|---|---|---|---|
| **3 à 5 $\mu$m** | 0-300 nm | 1900 $\pm$ 150 nm | 1300 $\pm$ 150 nm | 1900 $\pm$ 100 nm | |
| **8 à 10 $\mu$m** | 0-600 nm | 1700 $\pm$ 300 nm | 2900 $\pm$ 300 nm | 4000 $\pm$ 300 nm | 5300 $\pm$ 300 nm |
| **100 $\mu$m** | 0-4$\mu$m | 20 $\pm$ 2$\mu$m | 35 $\pm$ 2$\mu$m | 50 $\pm$ 2$\mu$m | 64 $\pm$ 2$\mu$m |

Bien entendu, ces valeurs déterminées pour une structure semiconductrice 10 selon la deuxième possibilité d'agencement sont directement transposables à une structure semiconductrice 10 selon la troisième possibilité d'agencement

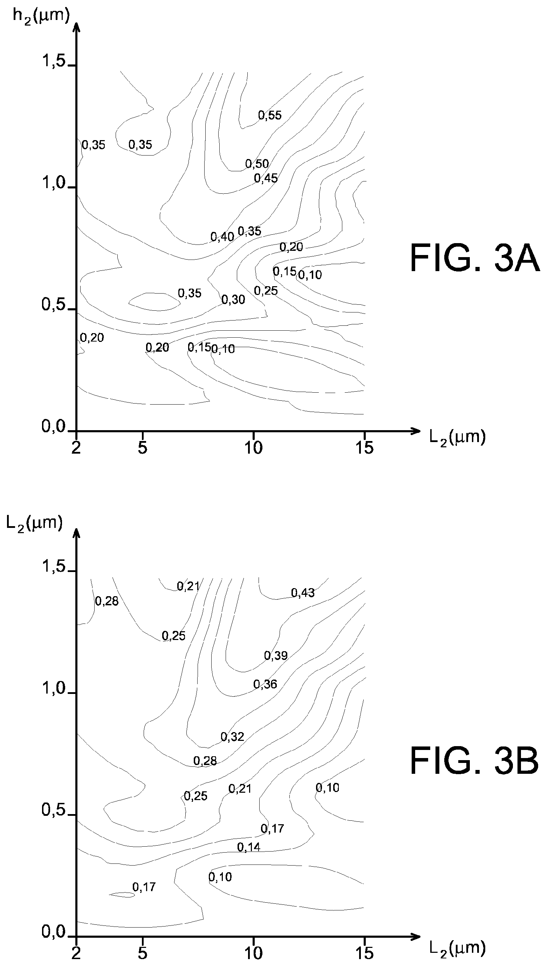

Les figures 3A et 3B illustrent l'influence du dimensionnement de la deuxième cavité sur l'efficacité quantique pour une gamme de longueurs d'onde de 8 à 10 $\mu$m, un pixel pitch de 15 $\mu$m et des espacements entre les cavités respectivement de 300 nm et 1900 nm, correspondant aux maxima d1 et d4 du Tableau 1. Pour ces deux graphiques, la structure semiconductrice 10 est selon la deuxième possibilité d'agencement et comporte une première cavité de section carrée dont les dimensions $L_1$ et $h_1$ sont respectivement fixées à 2 $\mu$m et à 800 nm pour les figures 3A et 3B. Les indices optiques de la première cavité, de l'espace 130 entre la première et la deuxième cavité 110, 120 et de la deuxième cavité ont été respectivement fixés à 3,4 + 0,2i, 3,4 et 1,4.

La figure 3A illustre ainsi la variation de l'efficacité quantique par rapport aux dimensions $L_2$ et $h_2$ de la deuxième cavité 120 dans la gamme de longueurs d'onde de 8 à 12 $\mu$m ; un pixel pitch de 15 $\mu$m et un espacement entre les cavités de 300 nm. On peut ainsi voir que si une efficacité quantique maximale peut être obtenue pour des dimensions $L_2$ et $h_2$ respectivement autour de 10 $\mu$m et 1,5 $\mu$m, plusieurs dimensionnements de la deuxième cavité 120 sont envisageables pour obtenir une efficacité quantique supérieure à 0,35.

Cette même observation peut être réalisée pour la figure 3B et la gamme de longueurs d'onde allant de 8 à 10 $\mu$m pour laquelle une efficacité quantique maximale peut être observée pour des dimensions $L_2$ et $h_2$ respectivement autour de 12,5 $\mu$m et 1,5 $\mu$m. De même, plusieurs dimensionnements de la deuxième cavité 120 sont envisageables pour obtenir une efficacité quantique supérieure à 0,28.

L'homme du métier est donc à même, à partir de ces calculs =de routines, de déterminer le dimensionnement de l'espace 130 entre la première et la deuxième cavité 110, 120, ou du support 130, et de la deuxième cavité 120 quelle que soit la gamme de longueurs d'onde prédéterminée.

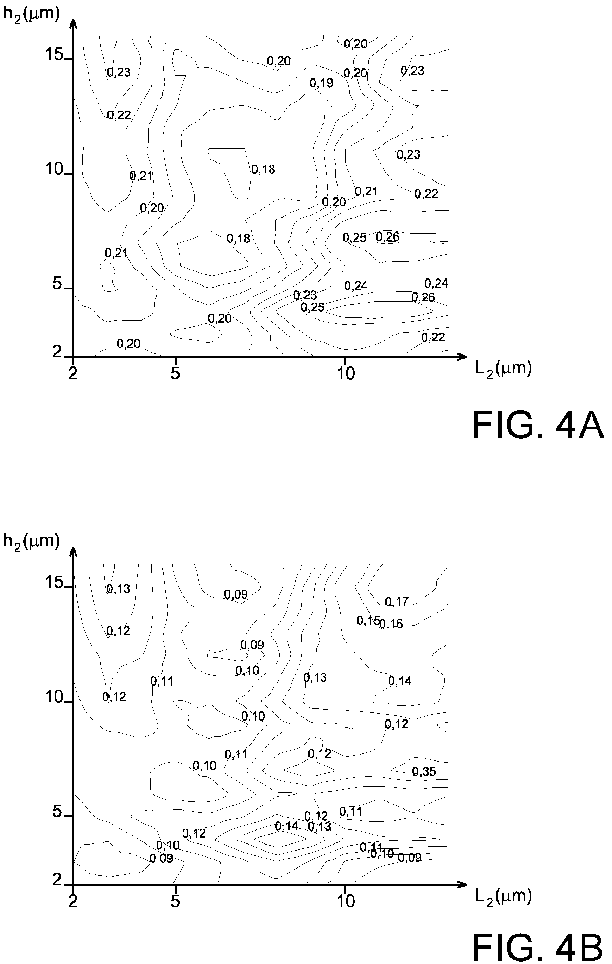

Un tel type de calculs peut également être adapté pour dimensionner une structure semiconductrice 10 selon le principe de l'invention qui comporte plus d'une première cavité. Ainsi les figures 4A et 4B illustrent la variation de l'efficacité quantique d'une structure semiconductrice comportant respectivement 4 et 6 premières cavités ceci en fonction des dimensions $L_2$ et $h_2$ de la deuxième cavité 120 et pour des conditions dimensionnelles de la structure semiconductrice 10 identiques à celles utilisées pour les calculs respectifs illustrés sur les figures 3A et 3B, un pixel pitch de 15 $\mu$m et une gamme spectrale entre 8 et 10 $\mu$m.

Les figures 5.1 à 5.6 illustrent un procédé de fabrication d'une structure semiconductrice 10 selon la troisième possibilité d'agencement selon l'invention dans laquelle la première cavité 110 comporte la zone active d'une photodiode classique. Un tel procédé comporte les étapes suivantes :

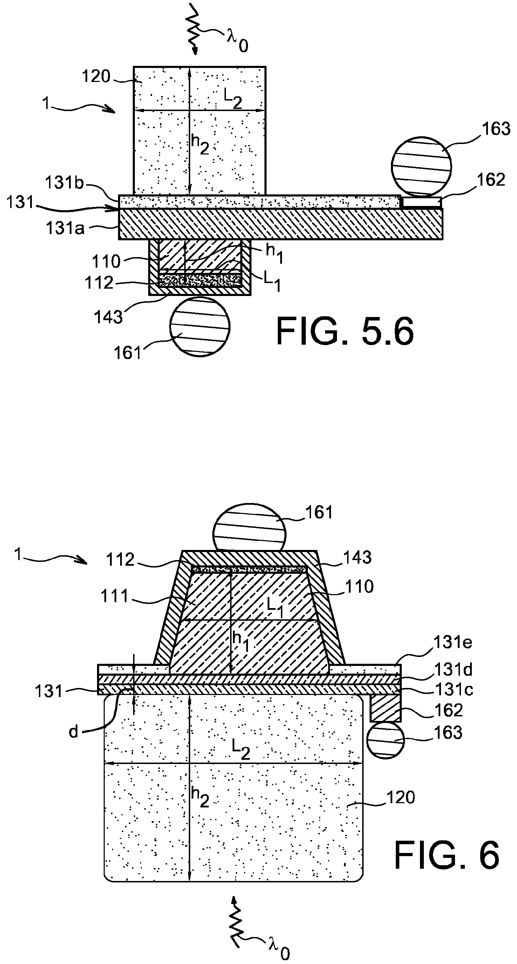

- fourniture d'un substrat 150, ledit substrat 150 comportant une première couche semiconductrice 131a d'un premier type de conductivité destinée à former l'une des zones dopées de la photodiode et à former partiellement le support 131,
- dépôt en contact de la première couche semiconductrice 131a d'une deuxième couche semiconductrice 111 d'un deuxième type de conductivité opposée au premier type de conductivité de manière à ce que la première et la deuxième couche semiconductrice 131a, 111 forment ensemble une structure du type photodiode classique, la concentration en éléments dopants de la deuxième couche semiconductrice 111 étant adaptée de manière à ce que la zone de charge d'espace s'étende dans la deuxième couche semiconductrice 111,
- passivation de la surface de la deuxième couche semiconductrice 111 qui est opposée de la première couche semiconductrice 131a par le dépôt d'une première couche de passivation 112, tel que cela est illustré sur la figure 5.1, la deuxième couche semiconductrice 111 et la première couche de passivation 112 présentant ensemble une épaisseur selon la direction z égale à $h_1$,
- gravure sélective de la deuxième couche semiconductrice 111 et de la première couche de passivation 112 de manière à former au moins partiellement la première cavité 110 avec au moins l'une de ces dimensions transversales à la direction z d'émission égale à $L_1$, tel que cela est illustré sur la figure 5.2,
- dépôt sélectif d'un matériau réfléchissant 143 métallique en contact avec la première cavité 111 sur ses côtés et sa partie opposée à la première couche semiconductrice 110, tel qu'illustré sur la figure 5.3, le matériau réfléchissant 143 étant en contact électrique sur les côtés de la première cavité 110 afin de fournir un premier contact métallique de la structure semiconductrice 1,
- dépôt d'une bille métallique 161, telle qu'une bille d'indium, à la surface du matériau réfléchissant 143 pour permettre une connexion par hybridation à un circuit de lecture, comme cela est illustré sur la figure 5.4,
- gravure du substrat 150 de manière à libérer la surface de la première couche semiconductrice 131a qui est opposée à la première cavité 110,
- passivation de la surface de la première couche semiconductrice 131a qui est opposée de la première cavité 110 par le dépôt d'une deuxième couche de passivation 131b, tel que cela est illustrée sur la figure 5.5, la première couche semiconductrice 131a et la deuxième couche de passivation 131b présentant ensemble une épaisseur selon la direction z égale à d,
- formation de la deuxième cavité 120 en contact de la deuxième couche de passivation 131b, la deuxième cavité 120 étant agencée pour intercepter au moins une partie de l'onde électromagnétique,
- libération dans la deuxième couche de passivation 131b d'une ouverture pour autoriser une prise de contact sur la première couche semiconductrice 131a,
- dépôt sélectif d'un plot de contact métalliques 162 en contact avec la première couche semiconductrice 131a sur l'ouverture dans la deuxième couche de passivation 112 qui a été libérée,
- dépôt d'une bille metallique 163, telle qu'une bille d'indium, à la surface du plot de contact métallique 16 pour permettre une connexion par hybridation à un circuit de lecture" comme cela est illustré sur la figure 5.6.

Cette dernière étape de formation de la deuxième cavité 120 peut être réalisée au moyen d'une résine photosensible à partir des sous-étapes suivantes :

- dépôt d'une couche de résine photosensible sur la surface de la couche de passivation 131b, par exemple par centrifugation,
- insolation d'une partie de la couche de résine photosensible, cette partie étant la partie destinée à former la deuxième cavité 120, si la résine photosensible est du type résine positive, ou le reste de la couche de résine photosensible, si cette dernière résine photosensible est du type résine négative,
- révélation de la deuxième cavité 120 par l'utilisation d'un solvant.

On peut noter, bien entendu, que la deuxième cavité 120 peut également être formée par des procédés classiquement utilisés dans la microélectronique. Selon cette possibilité, l'étape de formation de la deuxième cavité peut comporter les sous étapes suivantes :

- dépôt d'une couche du matériau diélectrique qui est destiné à la formation de la deuxième cavité 120 sur la surface de la couche de passivation 131b,
- dépôt d'une couche de résine photosensible,
- insolation sélective, ceci de manière à fournir une protection de la partie de la couche de matériau diélectrique qui est destinée à former la deuxième cavité 120,
- révélation de manière à libérer de couche de résine photosensible la partie de la couche de matériau diélectrique qui n'est pas destinée à former la deuxième cavité 120,
- attaque sélective de la couche de matériau diélectrique, la partie de cette couche de matériau diélectrique étant protégée par la résine photosensible, ceci de manière à former la deuxième cavité 120.

La figure 6 illustre une structure semiconductrice selon la troisième possibilité d'agencement dans laquelle la structure est du type photodétecteur de type barrière. Une telle structure semiconductrice 10 se différencie de celle obtenue avec le procédé de fabrication illustré par les figures 5.1 à 5.6 en ce que le support 131 comporte une première et une troisième couche semiconductrice 131c, 131d. La première couche semiconductrice 131c, opposée à la première cavité, forme l'une des zones dopées du photodétecteur de type barrière tandis que la troisième couche semiconductrice 131d forme la couche barrière de ce même photodétecteur. Ainsi, la première cavité 110 comportant l'autre zone dopée du photodétecteur, la première couche semiconductrice 131c et la première cavité 110 sont toutes deux d'un premier type de conductivité.

Pour rappel, une structure semiconductrice de type barrière comporte une première et une seconde zone du même type de conductivité séparées par une zone barrière. La première zone et la seconde zone, présentant un même type de conductivité, comportent des porteurs majoritaires identiques qui sont par définition les porteurs majoritaires de la structure. La zone barrière comporte une bande interdite adaptée pour faire barrière aux porteurs majoritaires et laisser passer les porteurs minoritaires. Pour ce faire, la zone barrière possède une largeur de bande interdite supérieure à celles de la première et de la seconde zone avec une différence d'énergie, entre les différentes zones, la plus faible possible pour la bande d'énergie correspondant aux porteurs minoritaires, c'est-à-dire, la bande de valence pour des porteurs minoritaires qui sont des trous, et la bande de conduction, pour des porteurs minoritaires qui sont des électrons. Ainsi, la zone barrière crée, par la différence de largeur de bande interdite avec la première et la seconde zone, une forte barrière de potentiel pour les porteurs majoritaires. Celle-ci est faible, voir annulée, pour les porteurs minoritaires, ceci en raison de la faible différence d'énergie pour la bande d'énergie correspondant aux porteurs minoritaires.

De cette manière, lorsque la première zone est polarisée en inverse, par rapport à la seconde zone, et qu'une paire électron-trou est générée par un photon dans la première zone, le porteur minoritaire généré passe de la première zone à la seconde zone, et est accéléré par la polarisation. Le porteur minoritaire est ainsi collecté au niveau de cette dernière.

Dans le cadre de la structure semiconductrice selon l'invention illustrée sur la figure 6, la première cavité 110 comporte la première zone dont le matériau est choisi pour permettre l'absorption de l'onde électromagnétique, ceci notamment avec une largeur de bande interdite adaptée. La deuxième zone et la zone barrière sont, quant à elles au moins en partie ménagées dans le support 131 et présente préférentiellement toutes deux des largeurs de bande interdite telles qu'elles sont sensiblement transparentes dans la gamme de longueurs d'onde prédéterminée. Selon cette possibilité, la première zone et la zone barrière présente une largeur de bande interdite plus importante que celle de la première zone barrière et dont l'énergie est supérieure à l'énergie correspondant à la borne inférieure de la gamme de longueurs d'onde prédéterminée.

Dans une application pratique d'une telle structure semiconductrice 10 pour la détection d'une onde électromagnétique dans la gamme de longueurs d'onde allant de 3,7 à 4.8 $\mu$m, la structure semiconductrice peut présenter le dimensionnement suivant :

$L_1$=900 nm, h1=900 nm, d=300 nm avec la première et la troisième couche semiconductrice 131c, 131d qui présentent respectivement une épaisseur de 100 et 200 nm, $L_2$= 3,5 $\mu$m et $h_2$=4 $\mu$m.

Selon cette application pratique avec une deuxième cavité 120 réalisée dans un verre d'indice optique $N_2$=1,4 et une première couche semiconductrice 131c et première cavité 110 toutes deux réalisées dans un tellurure de mercure-cadmium du type $Cd_{1-x}Hg_xTe$ dopée N avec x compris entre 0 et 1, il est possible d'atteindre une efficacité quantique de l'ordre de 35%.

Un procédé de fabrication d'une telle structure semiconductrice 10 se différencie du procédé de fabrication illustré sur les figures 5.1 à 5.6, en ce que :

- lors de l'étape de fourniture du substrat 150, le substrat 150 comporte une première et une troisième couche semiconductrice 131c, 131d, la première couche semiconductrice 131c étant d'un premier type de conductivité et la troisième couche semiconductrice 131d étant destinée à former une couche barrière,
- lors de l'étape de dépôt de la deuxième couche semiconductrice, la deuxième couche semiconductrice est du même type de conductivité que la première couche semiconductrice 131d,
- aucune étape de passivation de la surface de la première couche semiconductrice 131c n'est mise en oeuvre.

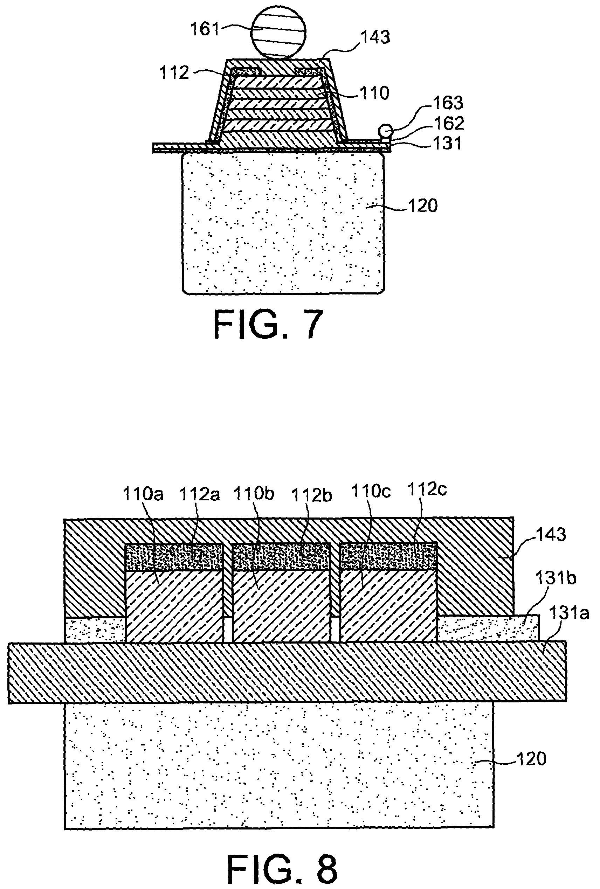

La figure 7 illustre une structure semiconductrice 10 selon la troisième possibilité d'agencement de l'invention dans laquelle la structure semiconductrice 10 est du type photodiode à puits quantiques. Une telle structure semiconductrice 10 se différencie de la structure illustrée sur la figure 5 en ce que la première cavité comporte une pluralité de sous-couches formant, d'une part, une zone intrinsèque comportant une pluralités de puits quantiques, et, d'autre part, une zone semiconductrice dopée, et en ce que la premier cavité 110 est polarisée au niveau de sa partie qui est opposée à la deuxième cavité 120.

Ainsi une telle structure semiconductrice 10, contrairement à celle illustrée sur la figure 5.6, comporte la première couche de passivation 112 sur les côtés de la première cavité 110 et au moins une ouverture de cette dernière couche de passivation 112 au niveau de la partie de la première cavité 110 opposée à la deuxième cavité 120 ceci de manière à permettre un contact métallique entre ladite partie et le matériau réfléchissant 143 métallique.

Le procédé de fabrication d'une telle structure semiconductrice se différencie du procédé de fabrication illustré sur les figures 5.1 à 5.6 en ce que :

- lors de l'étape de dépôt de la deuxième couche semiconductrice 111 cette dernière est constituée d'une pluralité de sous-couches formant, d'une part, une zone intrinsèque comportant une pluralité de puits quantiques et, d'autre part, une zone semiconductrice dopée,
- l'étape de passivation de la deuxième couche semiconductrice 111 est réalisée après la gravure de la deuxième couche semiconductrice 111 de manière à passiver la surface de la première couche semiconductrice 131a opposée au substrat, les côtés de la première cavité 110 et la partie de la première cavité 110 qui est opposée à la deuxième cavité 120,
- après l'étape de passivation, il est prévu une étape de gravure partielle de la première couche de passivation 112 afin de former au moins une ouverture de la première couche de passivation 112 au niveau de la partie de la première cavité 110 qui est opposée à la première cavité 110,
- l'étape de dépôt du matériau réfléchissant est réalisée de manière à ce que le matériau réfléchissant emplisse l'ouverture dans la première couche de passivation 112 et à fournir ainsi un contact métallique entre le matériau réfléchissant 143 et la première couche semiconductrice 111 ;
- il n'est pas effectué d'étape de passivation de la surface première couche semiconductrice 131a qui est opposée de la première cavité 110.

La figure 8, illustre schématiquement la possibilité d'une structure semiconductrice selon l'invention comportant plusieurs premières cavités 110a, 110b, 110c. Ainsi la structure semiconductrice 10 selon la figure 8, dans le plan de coupe illustré sur la figure 8 comporte trois premières cavités 110a, 110b, 110c, ce qui correspond, pour une structure de forme sensiblement carrée, à neuf premières cavités.

Une telle structure semiconductrice 10 se différencie d'une structure semiconductrice 10 selon la troisième possibilité d'agencement en ce qu'elle comporte la pluralité de premières cavités 110a, 110b, 110c, le matériau réfléchissant 143 recouvrant les premières cavités 110a, 110b, 110c.

Le dimensionnement des premières cavités 110a, 110b, 110c d'une telle structure semiconductrice 10 respecte les mêmes conditions que celle d'une structure semiconductrice 10 selon la troisième possibilité d'agencement de l'invention. Les premières cavités sont agencées pour être chacune couplée avec la deuxième cavité 120 et de manière à ce que la deuxième cavité 120 intercepte au moins une partie de l'onde électromagnétique.

Selon cette possibilité, le nombre et le positionnement des premières cavités 110a, 110b, 110c peut être optimisés. En effet, il est possible et avantageux de prévoir le positionnement de chacune des cavités pour qu'elle soit positionnée, par rapport à la résonnance, au niveau d'un ventre de la vibration, c'est-à-dire à un pic de résonnance, de la deuxième cavité 120.

Le procédé de fabrication d'une structure semiconductrice 10 comportant plusieurs premières cavités 110a, 110b, 110c se différencie d'un procédé de fabrication tel qu'illustré sur les figures 5.1 à 5.6 en ce que :

- lors de l'étape de gravure de la deuxième couche semiconductrice, la gravure est réalisée de manière à former au moins partiellement les premières cavités 110a, 110b, 110c avec au moins l'une de ces dimensions transversales à la direction z d'émission égale à $L_1$,
- l'étape de passivation de la surface de la deuxième couche semiconductrice 111 est substituée par une étape de passivation de la partie de la première cavité 110 opposée à la deuxième cavité 120 et de la surface de la première couche semiconductrice 131 mise en oeuvre après l'étape de gravure de la deuxième couche semiconductrice 111.

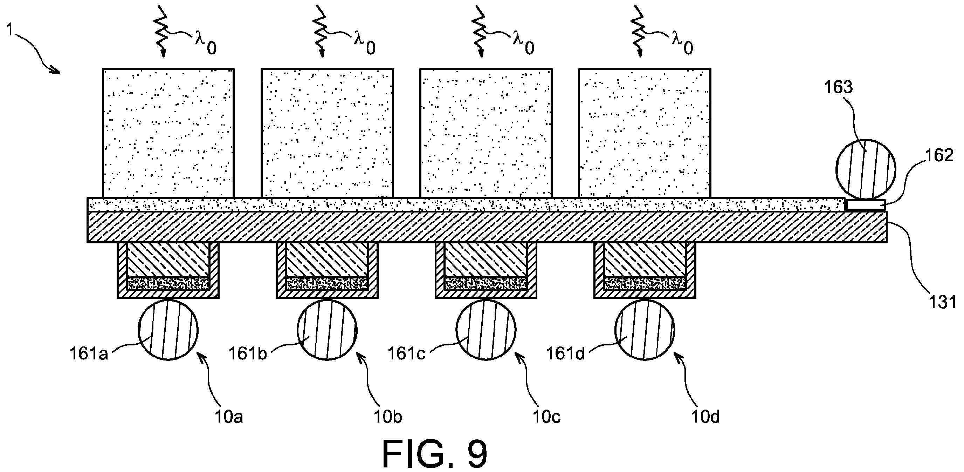

Quelle que soit la possibilité d'agencement des structures semiconductrices 10 selon l'invention et la configuration de ces dernières, de telles structures peuvent équiper un composant semiconducteur 1. La figure 9 illustre un tel composant semiconducteur 1, ledit composant semiconducteur 1 comportant quatre structures semiconductrices du même type que celle illustrée sur la figure 5.6.

Dans un tel composant 1, comme cela est illustré sur la figure 9, la configuration est similaire à celle décrite pour une structure semiconductrice 10 seule, à la différence près que le support 131 étant commun, un seul contact 162 est nécessaire pour polariser la première couche semiconductrice 131a. Ainsi chacune des structures semiconductrices 10a, 10b, 10c, 10d, présente une bille d'indium 161a, 161b, 161c, 161d qui lui est propre en contact avec le matériau réfléchissant 143a, 143b, 143c, 143d pour permettre la polarisation de sa zone active.

Le procédé de fabrication d'un tel composant semiconducteur 1 comportant plusieurs structures semiconductrices 10a, 10b, 10c, 10d se différencie d'un procédé de fabrication d'une seule structure semiconductrice en ce que les étapes permettant la fabrication de la première et la deuxième cavité sont adaptées de manière à permettre la fabrication de plusieurs premières et deuxièmes cavités de manière similaire au procédé de fabrication d'une structure semiconductrice 10 tel qu'illustrée sur la figure 8 qui permet l'obtention de plusieurs premières cavités 110a, 110b, 110c.

**Revendications**

1. Structure semiconductrice (10) apte à absorber une onde électromagnétique dans une gamme de longueurs d'onde prédéterminée qui est centrée autour d'une longueur d'onde $\lambda_0$,
   la structure semiconductrice (10) comportant :

   - au moins une première cavité (110) optique résonnante semiconductrice dont une longueur d'onde de résonnance est comprise dans la gamme de longueurs d'onde prédéterminée et est préférentiellement égale à la longueur d'onde $\lambda_0$, ladite première cavité (110) étant conformée pour absorber au moins partiellement l'onde électromagnétique et pour fournir un signal électrique proportionnel à la partie absorbée de l'onde électromagnétique,

   la structure semiconductrice (10) étant **caractérisée en ce qu'**elle comprend en outre :

   - une deuxième cavité (120) optique résonante diélectrique dont une deuxième longueur d'onde de résonnance est comprise dans la gamme de longueurs d'onde prédéterminée et est préférentiellement égale à la longueur d'onde $\lambda_0$, la deuxième cavité (120) étant agencée pour intercepter au moins une partie de l'onde électromagnétique et étant couplée optiquement à la première cavité (110),

   la deuxième cavité (120) étant transparente à la gamme de longueurs d'onde prédéterminée.

**2.** Structure semiconductrice (10) selon la revendication 1, dans laquelle la deuxième cavité (120) comporte un indice optique $N_2$ inférieur à 2 et préférentiellement inférieur ou égal à 1,4.

**3.** Structure semiconductrice (10) selon la revendication 2, dans laquelle la deuxième cavité (120) est réalisée dans un matériau sélectionné dans le groupe comportant les verres, les polymères thermoplastiques, les élastomères, les polymères thermodurcissables, les résines photosensibles et les mélanges de deux ou plus de ces matériaux

**4.** Structure semiconductrice (10) selon la revendication 1 ou 2, dans laquelle la structure semiconductrice (10) est destinée à recevoir l'onde électromagnétique selon une direction d'émission (z) moyenne,
la première cavité (110) étant dimensionnée pour présenter au moins une première direction de résonance, correspondant à la première longueur d'onde de résonance, qui est sensiblement transversale à la direction d'émission (z).

**5.** Structure semiconductrice (10) selon la revendication 4, dans laquelle la première cavité (110) présente une première largeur $L_1$ selon la première direction de résonance,
et dans laquelle la deuxième cavité (120) présente selon au moins cette même première direction de résonance

une deuxième largeur $L_2$ respectant l'équation suivante : $L_2 = L_1 \times M \times \dfrac{N_2}{N_1}$, avec $L_2$ la deuxième largeur, $L_1$

la première largeur, M un nombre entier impair supérieur ou égal 1, $N_1$ et $N_2$ les indices optiques respectif de la première et la deuxième cavité (110, 120).

**6.** Structure semiconductrice (10) selon l'une quelconque des revendications 1 à 5, comprenant un support (131) présentant une première et une deuxième face opposée l'une à l'autre, la première cavité (110) étant disposée en contact sur la première face et la deuxième cavité (120) étant disposée en contact sur la deuxième face, le support (131) étant dimensionné afin d'assurer le couplage optique entre la première et la deuxième cavité (110, 120)

**7.** Structure semiconductrice (10) selon l'une quelconque des revendications 1 à 6, dans laquelle la structure semiconductrice (10) est une structure du type sélectionnée dans le groupe comportant les photodiodes du type pin, les photodiodes à puits quantiques, les photodétecteurs de type barrière,
et dans laquelle une zone active de ladite structure semiconductrice (10) est aménagée dans la première cavité (110).

**8.** Structure semiconducteur (10) selon l'une quelconque des revendication 1 à 7, comprenant au moins deux premières cavités (110a, 110b, 110c), lesdites premières cavités (110a, 110b, 110c) étant chacune couplée optiquement à la deuxième cavité (120).

**9.** Composant semiconducteur (1) comportant une pluralité de structures semiconductrices (10a, 10b, 10c, 10d) chacune destinée à recevoir une onde électromagnétique, ledit composant (1) étant **caractérisé en ce qu'**au moins l'une, préférentiellement la totalité, des structures semiconductrices (10a, 10b, 10c 10d) est une structure semiconductrice (10) selon l'une quelconque des revendications 1 à 8.

**10.** Procédé de fabrication d'une structure semiconductrice (10) apte à absorber une onde électromagnétique dans une gamme de longueurs d'onde prédéterminée qui est centrée autour d'une longueur d'onde $\lambda_0$,
le procédé comportant les étapes suivantes :

- fourniture d'au moins une première cavité (110) optique résonnante semiconductrice dont une première longueur d'onde de résonance est comprise dans la gamme de longueurs d'onde prédéterminée et est préférentiellement égale à la longueur d'onde $\lambda_0$, ladite première cavité (110) étant conformée pour absorber au moins partiellement l'onde électromagnétique et pour fournir un signal électrique proportionnel à la partie absorbée de l'onde électromagnétique,
- fourniture d'une deuxième cavité (120) optique résonante diélectrique dont une deuxième longueur d'onde de résonance est comprise dans la gamme de longueurs d'onde et est préférentiellement égale à la longueur d'onde $\lambda_0$, la deuxième cavité (120) étant agencée pour intercepter une partie de l'onde électromagnétique et étant couplée optiquement à la première cavité (110),

la deuxième cavité (120) étant transparente à la gamme de longueurs d'onde prédéterminée.

**11.** Procédé de fabrication selon la revendication 10 dans lequel l'étape de fourniture de la première cavité (110) comporte les sous-étapes suivantes :

- fourniture d'un support (131) semiconducteur comportant une première et une deuxième face,
- formation de la première cavité (110) en contact avec la première face du support,

et dans lequel l'étape de fourniture d'une deuxième cavité (120) consiste à former ladite deuxième cavité (120) en contact avec la deuxième face du support (131).

**12.** Procédé de fabrication selon la revendication 11 dans lequel l'étape de fourniture de la deuxième cavité (120) comporte les sous-étapes suivantes :

- dépôt d'une couche de résine photosensible sur la surface du support (131), par exemple par centrifugation,
- insolation d'une partie de la couche de résine photosensible, cette partie étant la partie destinée à former la deuxième cavité (120), si la résine photosensible est du type résine positive, ou le reste de la couche de résine photosensible, si cette dernière u résine photosensible est du type résine négative,
- révélation de la deuxième cavité (120) par l'utilisation d'un solvant.

FIG. 1

FIG. 2A

FIG. 2B

FIG. 3A

FIG. 3B

FIG. 4A

FIG. 4B

FIG. 5.1

FIG. 5.2

FIG. 5.3

FIG. 5.4

FIG. 5.5

FIG. 5.6

FIG. 6

FIG. 7

FIG. 8

FIG. 9

EP 3 051 594 A1

Europäisches
Patentamt

European
Patent Office

Office européen
des brevets

# RAPPORT DE RECHERCHE EUROPEENNE

Numéro de la demande

EP 16 15 3424

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 5 455 421 A (SPEARS DAVID L [US]) 3 octobre 1995 (1995-10-03) * abrégé; figures 1-4 * * colonne 2, ligne 45 - ligne 64 * * colonne 3, ligne 38 - colonne 4, ligne 29 * * colonne 5, ligne 15 - ligne 27 * * colonne 5, ligne 43 - colonne 6, ligne 66 * ----- | 1-4,6-10 | INV. H01L31/0216 H01L31/103 H01L31/105 |
| X | US 4 731 640 A (BLUZER NATHAN [US]) 15 mars 1988 (1988-03-15) * abrégé; figures 3,6,7 * * colonne 5, ligne 64 - colonne 7, ligne 8 * * colonne 9, ligne 40 - colonne 12, ligne 2 * * colonne 13, ligne 18 - ligne 47 * * colonne 15, ligne 24 - ligne 33 * ----- | 1,4,8-10 | |
| A | QIN WANG ET AL: "Micro-optical elements functioning in non-visible spectral range", PROCEEDINGS OF SPIE, vol. 7716, 30 avril 2010 (2010-04-30), pages 771609-771609-9, XP055235147, US ISSN: 0277-786X, DOI: 10.1117/12.853959 ISBN: 978-1-62841-730-2 * le document en entier * ----- | 1-3, 7-10,12 | **DOMAINES TECHNIQUES RECHERCHES (IPC)** H01L |

-/--

Le présent rapport a été établi pour toutes les revendications

| Lieu de la recherche | Date d'achèvement de la recherche | Examinateur |
|---|---|---|
| Berlin | 24 mai 2016 | Sagol, Bülent Erol |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.................................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 16 15 3424

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | ROCHA RUI PEDRO ET AL: "Low f-Number Microlenses for Integration on Optical Microsystems", IEEE SENSORS JOURNAL, IEEE SERVICE CENTER, NEW YORK, NY, US, vol. 15, no. 7, 23 décembre 2014 (2014-12-23), pages 4073-4075, XP011582096, ISSN: 1530-437X, DOI: 10.1109/JSEN.2014.2385476 [extrait le 2015-05-19] * le document en entier * | 1-3, 7-10,12 | |
| A | NATHAN MENACHEM: "Microlens reflector for out-of-plane optical coupling of a waveguide to a buried silicon photodiode", APPLIED PHYSICS LETTERS, AMERICAN INSTITUTE OF PHYSICS, 2 HUNTINGTON QUADRANGLE, MELVILLE, NY 11747, vol. 85, no. 14, 4 octobre 2004 (2004-10-04), pages 2688-2690, XP012062741, ISSN: 0003-6951, DOI: 10.1063/1.1803617 * le document en entier * | 1-3, 7-10,12 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Berlin | 24 mai 2016 | Sagol, Bülent Erol |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
...............................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 16 15 3424

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-05-2016

| Document brevet cité au rapport de recherche | Date de publication | Membre(s) de la famille de brevet(s) | Date de publication |
|---|---|---|---|
| US 5455421 A | 03-10-1995 | AUCUN | |
| US 4731640 A | 15-03-1988 | AUCUN | |

Pour tout renseignement concernant cette annexe : voir Journal Officiel de l'Office européen des brevets, No.12/82

EPO FORM P0460

## RÉFÉRENCES CITÉES DANS LA DESCRIPTION

**Documents brevets cités dans la description**

- FR 2992471

- FR 2985373

**Littérature non-brevet citée dans la description**

- *Journal of Applied Physics,* 1993, vol. 74, R1-R81